# EUROPÄISCHE PATENTSCHRIFT

(11) **EP 0 951 205 B1**
(45) Veröffentlichungstag und Bekanntmachung des Hinweises auf die Patenterteilung: **04.12.2002**
(21) Anmeldenummer: 99112212.8
(22) Anmeldetag: 24.08.1995
(51) Int. Cl.: H05K 3/34, H05K 13/04

(54) **Verfahren zum automatischen Bestücken der Ober- und Unterseite von Leiterplatten mit SMD-Bauteilen**
Process for automatic assembling of the upper and lower side of printed circuit boards with SMD components
Procédé d'assemblage automatique de la face supérieure et inférieure de plaques à circuit imprimé avec des composants CMS

(30) Priorität: 20.09.1994 DE 4433378
(43) Veröffentlichungstag der Anmeldung: 20.10.1999
(62) Teilanmeldung aus: 95928970.3
(73) Patentinhaber: Blaupunkt-Werke GmbH, 31132 Hildesheim (DE)
(72) Erfinder: Sabotke, Jens, 31139 Hildesheim (DE); Graen, Ansgar, 31199 Diekholzen (DE); Heinrich, Hans-Walter, 31139 Hildesheim (DE)
(74) Vertreter: Voss, Klaus, Dipl.-Ing.

(56) Entgegenhaltungen:
- DE-A- 3 113 031
- US-A- 4 926 546
- US-A- 5 155 904
- "Technologie du montage en surface des composants: les procédés de montage et de brasure" TOUTE L'ELECTRONIQUE, Nr. 516, Seiten 54-63, XP002051269 PARIS FR
- PATENT ABSTRACTS OF JAPAN vol. 17, no. 528 (E-1437), 22. September 1993 (1993-09-22) & JP 05 145214 A (TEAC CORP.), 11. Juni 1993 (1993-06-11)

## Beschreibung

Gegenstand des Schutzrechtes ist ein Verfahren zum automatischen Bestükken der Ober- und Unterseite von Leiterplatten mit SMD-Bauteilen.

Die zu bestückenden Leiterplatten weisen in der Regel auf ihrer Unterseite ein Netz von Leiterbahnen auf, die die darin vorgesehenen Anschlußpunkte der Bauelemente funktionsgerecht miteinander verbinden. Diese Leiterplatten durchlaufen mittels eines Transportbandes die einzelnen Bearbeitungsstationen und passieren dabei auch Einrichtungen zum Bestücken der Leiterplatte von oben, sogenannte Bestückungsautomaten oder SMD-Bestücker, die die Bauteile in vorgegebene Positionen auf der Oberseite der Leiterplatte bringen. Dazu verfügen die Bestückungsautomaten über Greiforgane, die sich in einer horizontalen Ebene zu jedem Punkt der Leiterplattenoberfläche steuern lassen. Die Bauteile selbst sind auf einen Träger bevorratet, der in vielen Fällen zu einer Rolle aufgerollt ist. Von diesem Träger werden die Bauteile nacheinander, z. B. von einem Bestücksauger, abgenommen und zu der vorgesehenen Position verbracht.

Nach dem Absetzen aller für die auf der Leiterplatte dargestellten Schaltungen erforderlichen SMD-Bauteile werden die Bauteile mit ihren Anschlußpunkten in einer Lötstation verlötet, und danach wird die Schaltung auf ihre einwandfreie Funktion hin geprüft.

Der Wunsch, den Raumbedarf dieser Schaltungen möglichst gering zu halten, hat dazu geführt, SMD-Bauelemente auch auf der Unterseite der Leiterplatten anzuordnen. Dazu wird nach der Lötstation die Leiterplatte vom Transportband abgehoben und gewendet und die nunmehr obenliegende Unterseite der Leiterplatte an den dortigen Plazierungen für SMD-Bauteile mit einem Kleber versehen. Anschließend durchläuft die Leiterplatte einen zweiten Bestückungsautomaten oder SMD-Bestücker und dort wird die nunmehr nach oben weisende Unterseite der Leiterplatte mit weiteren SMD-Bauteilen bestückt.

Ein Verfahren, bei den Ober- und Unterseite der Leiterplatte bestückt werden, ist aus der US-A-4 926 546 bekannt.

Hinter dem zweiten Bestückungsautomaten wird der Kleber in einer Härtestation ausgehärtet, so daß die Bauelemente fest auf der Leiterplatte haften; anschließend wird die Leiterplatte wieder gewendet, und danach durchläuft die Leiterplatte eine Wellenlötstation, um die Bauteile auf der Unterseite mit den Leiterbahnen zu verlöten.

Gegebenenfalls werden vorher noch Bauelemente von Hand auf die Oberseite der Leiterplatte aufgesetzt, die nicht mit einem Bestücksauger manipulierbar sind.

Der Erfindung lag die Aufgabe zugrunde, falls möglich, diesen Aufwand zu verringern.

Die Lösung dieser Aufgabe besteht in dem Verfahren mit den Merkmalen des Anspruchs 1, die darin gesehen werden, daß die an vorgegebenen Stellen mit Lötpaste bedruckte Oberseite einer Leiterplatte und die an vorgegebenen Stellen mit Kleberauftrag versehene Unterseite einer zuvor gewendeten Leiterplatte nebeneinander und taktgleich durch denselben SMD-Bestücker transportiert werden und somit einen Bestückungsnutzen bilden.

Der Druck mehrerer Leiterplatten auf einem einzigen Bestückungsnutzen, sogenannte Mehrfachleiterplatten, ist an sich allgemein bekannt. Diese Mehrfachleiterplatten bedürfen jedoch nach der Bedruckung mit Lötpaste und nach der Bestückung und Lötung der Trennung voneinander. Verfahren zur Auftrennung eines Mehrleiterplattenbestückungsnutzens in die einzelnen Leiterplatten sind z. B. aus der DE 38 06 984 A1 und der DE 38 05 487 C2 bekannt. Aus der Anmeldung P 43 42 885 vom 16.12.1993 ist es aus dem dort geschilderten Stand der Technik auch bekannt, Leiterplatten im Nutzenverbund zu liefern, wobei die Abnehmer einen nahezu 100%igen Gut-Nutzen erwarten. Zu diesem Zweck wird dort vorgeschlagen, die einzelnen Leiterplatten in einem Bestückungsnutzen bereits vor der Bestückung mit einer Trennfuge zu versehen, mit deren Hilfe die als defekt erkannten Leiterplatten aus dem Bestückungsnutzen getrennt werden können, wobei der Fugenverlauf derart gewählt ist, daß intakte Leiterplatten, die z. B. zuvor in einem anderen Nutzen übriggeblieben waren, formschlüssig in den Bestückungsnutzen einsetzbar sind.

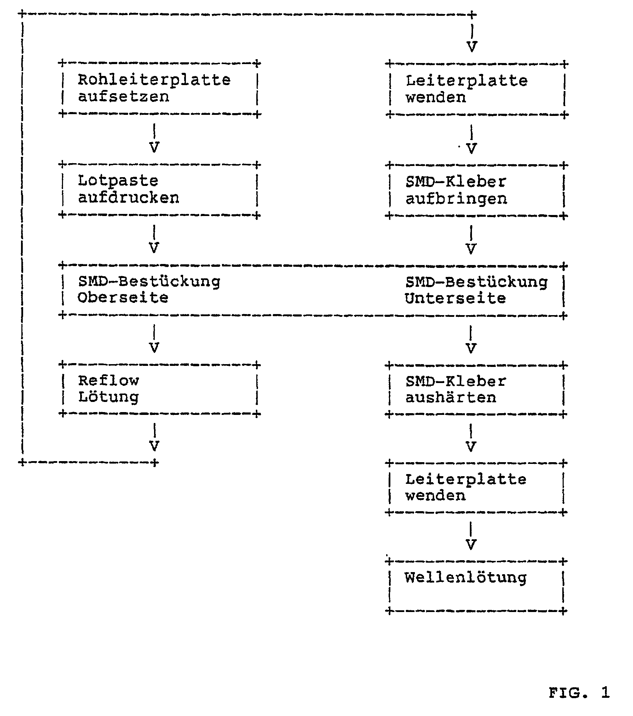

Anhand der Zeichnung wird nun ein Ausführungsbeispiel näher erläutert. Dabei zeigt
- Fig. 1: ein allgemeines Funktionsblockdiagramm des Verfahrens,
- Fig. 2: ein stärker differenziertes Funktionsblockdiagramm des Ausführungsbeispieles,
- Fig. 3: einen Querschnitt durch einen SMD-Bestücker zur Durchführung des erfindungsgemäßen Verfahrens.

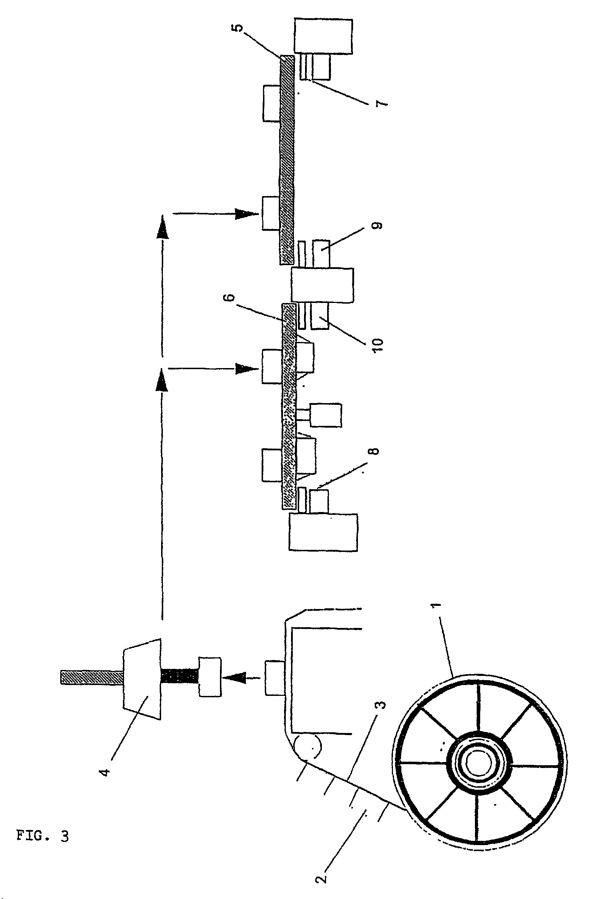

Das Verfahren beginnt mit der Entnahme der Rohleiterplatte aus einem Vorratsbehälter und deren Aufsetzen mit nach oben weisender Oberseite auf ein Transportband. Auf diese Seite der Rohleiterplatte wird danach in der Lotpastendruckstation an den Lötstellen für die zu bestückenden SMD-Bauteile, aber auch an den Kontaktbohrungen für Verbindungen von Leiterbahnen auf der Oberseite mit solchen auf der Unterseite der Leiterplatte in an sich bekannter Weise Lötpaste aufgedruckt. Anschließend durchläuft die Leiterplatte einen SMD-Bestücker auf dem Transportband, das von der ersten von zwei im SMD-Bestücker vorhandenen Aufnahmen für Transportbänder geführt wird. Ein Querschnitt durch diesen SMD-Bestücker ist in Fig. 3 näher dargestellt und wird später noch erläutert.

An den Ausgang der ersten Aufnahme in dem SMD-Bestücker schließt sich eine Reflow-Lötstation an, in der die Leiterplatten mittels Infrarotstrahlern erhitzt werden, so daß das Lot in der Lotpaste schmilzt, wobei die anderen Bestandteile der Lotpaste verdampfen. Sodann wird die Transportrichtung der Leiterplatten um 180 Grad gedreht und die Leiterplatte zum Eingang der Einfichtung zurückgebracht.

Vor dem Eingang der zweiten Aufnahme für ein Transportband im SMD-Bestükker wird die Transportrichtung der Leiterplatte erneut um 180 Grad gedreht, und die Leiterplatten durchlaufen anschließend zunächst einen Leiterplattenwender, der die Unterseite der Leiterplatte in bekannter Weise nach oben wendet, und eine Kleberstation, in welcher an den Plazierungen der SMD-Bausteine punktförmig Kleber zwischen den Bauteileanschlußlötstellen aufgetragen wird. Das Transportband läuft sodann in die zweite Aufnahme in den SMD-Bestücker ein und wird nun taktgleich neben dem Transportband in der ersten Aufnahme geführt, wobei die auf beiden Bändern transportierten Leiterplatten derart aufeinander ausgerichtet sind, daß sie für den SMD-Bestücker einen einzigen Bestückernutzen bilden.

In dem SMD-Bestücker wird der Bestücksauger an die Plazierungen für SMD-Bauteile auf beiden nebeneinanderliegenden Oberflächen von Leiterplatten gesteuert und auf beiden Oberflächen, nämlich die Oberseite einer neu eingesetzten Rohleiterplatte und die Unterseite einer bereits oberseitig bestückten und danach gewendeten Leiterplatte, werden SMD-Bauteile aufgesetzt. Die Bauteile haften auf der Oberseite der neuen Rohleiterplatte in der Lötpaste bis zur anschließenden Reflow-Lötung fest, während sie auf der Unterseite von Kleber gehalten werden.

Hinter dem Ausgang der zweiten Aufnahme in dem SMD-Bestücker ist dann eine Härtestation für den Kleber angeordnet. Danach wird die Leiterplatte erneut gewendet und schließlich die SMD-Bauteile auf der Unterseite in einem Wellenlötbad mit den Anschlußpunkten verlötet.

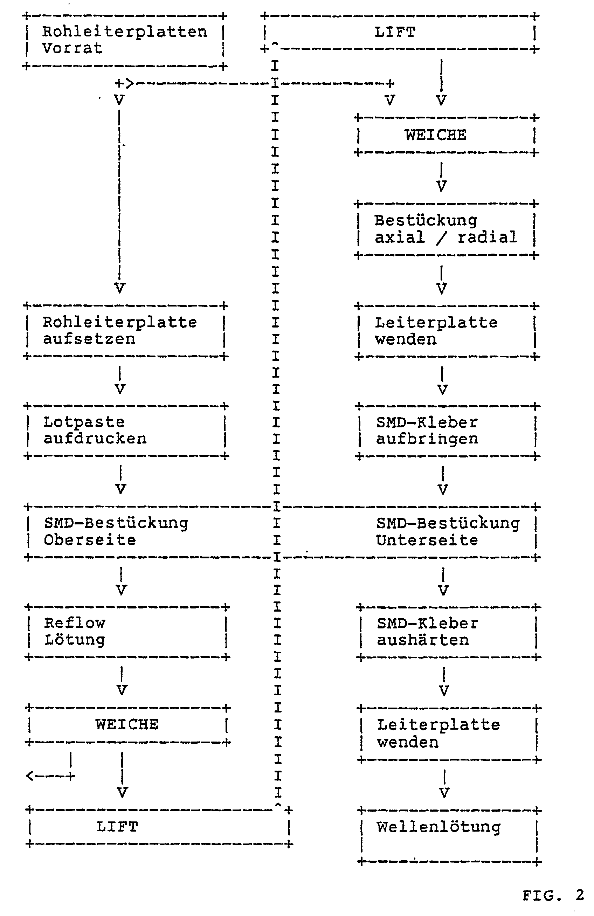

In dem bisher geschilderten Verfahrensablauf können im Bedarfsfall Prüfstationen und, wie in Fig. 2 angedeutet, Bestückungsplätze für Bauelemente mit radialen oder axialen Anschlüssen oder auch für Abschirmungen bzw. Gehäuseteilen integriert werden, die mit den leitenden Flächen auf der Leiterplatte verlötet werden sollen.

Die Umkehrstationen für Laufrichtung der Leiterplatten können auch, falls es die Räumlichkeiten erfordern, z. B. vor der Reflow-Station, in den Verfahrensablauf integriert werden, so daß diese bereits im Rücklauf der Leiterplatte liegt.

Auch kann die Wendestation direkt hinter dem Ausgang der Reflow-Station integriert sein und erst danach die Transportrichtung erneut umgekehrt werden.

Wesentlich ist, daß die beiden ausgedehnten Oberflächen der Leiterplatte trotz Bedruckung mit unterschiedlichen Haftmitteln für die SMD-Bauteile in dem SMD-Bestücker während des Bestückungsvorgangs zu einem Bestückungsnutzen zusammengeführt sind.

Bei dem in Fig. 2 dargestellten, erweiterten Funktionsblockdiagramm ist hinter der Reflow-Lötstation eine Weiche vorgesehen, in der Leiterplatten, die nur auf der Oberseite mit SMD-Bauteilen bestückt werden sollen, aus dem Ablauf des weiteren erfindungsgemäßen Verfahrens ausgeschleust werden können. Die im Verfahrenslauf verbleibenden Leiterplatten werden dann in einem Lift von dem Transportband abgehoben und über ein rücklaufendes zweites Transportband zu einem zweiten Lift zurückgebracht, der die Leiterplatten auf ein drittes wieder vorlaufendes Transportband aufsetzt. Auf diesen Lift folgt eine zweite Weiche, in der Rohleiterplatten, deren Oberseite nicht mit SMD-Bauteilen bestückt werden sollen, aus dem Vorratsbehälter in den weiteren Ablauf des Verfahrens eingeschleust werden können.

Hinter dieser zweiten Weiche ist eine Station zur Bestückung der Oberseite der Leiterplatte mit Radial- oder Axial-Bauelementen vorgesehen. Diese Bauelemente haben Anschlußdrähte, die entweder in radialer oder in axialer Richtung weisen. Nach dieser Bestückung wird die Leiterplatte, wie bereits beschrieben, gewendet, danach der Kleber aufgetragen und sodann die Leiterplatte auf dem von der zweiten Aufnahme geführten Transportband durch den SMD-Bestücker transportiert. Anschließend wird der Kleber ausgehärtet, die Leiterplatte erneut gewendet und die auf der Unterseite bestückten, vom Kleber gehaltenen SMD-Bauteile verlötet.

Der in Fig. 3 schematisch dargestellte Querschnitt durch einen SMD-Bestücker zeigt auf der linken Seite eine SMD-Bauteilevorratsrolle 1, von der die SMD-Bauteile 2 mit ihrem Trägerband 3 abgewickelt werden. Der Träger wird sodann unter einem Bestücksauger 4 hindurchgeführt, der die SMD-Bauelemente in bekannter Weise vom Träger abhebt. Der Bestücksauger 4 fährt mit dem SMD-Bauteil anschließend nach rechts über die Oberfläche zweier Leiterplatten 5 und 6, die nebeneinander auf zugeordneten Transportbändern 7 und 8 aufliegen und für den SMD-Sauger einen einzigen Bestückungsnutzen bilden. Die Transport bänder ihrerseits werden in zwei nebeneinander angeordneten Aufnahmen 9 und 10 geführt.

Entsprechend den Befehlen in dem Steuerprogramm des Bestückungssaugers werden nun nacheinander die SMD-Bauteile 2 auf den zu diesem Zeitpunkt einen Bestückungsnutzen bildenden mit unterschiedlichen Haftmitteln bedruckten Oberflächen der Leiterplatten auf ihren zugeordneten Plazierungen abgesetzt. Dabei ist die untenliegende "Oberseite" der linken Leiterplatte bereits mit SMD-Bauteilen 2 sowie mit weiteren Bauelementen mit axialen Anschlußdrähten bestückt.

## Patentansprüche

1. Verfahren zum automatischen Bestücken der Ober- und Unterseite von Leiterplatten mit SMD-Bauteilen,
wobei
die an vorgegebenen Stellen mit Lötpaste bedruckte Oberseite einer Leiterplatte (5) und die an vorgegebenen Stellen mit Kleberauftrag versehene Unterseite einer zuvor gewendeten Leiterplatte (6) zur Bildung eines einzigen Bestückungsnutzens nebeneinander und taktgleich durch denselben SMD-Bestücker transportiert werden.

## Claims

1. Process for automatically inserting SMD components on the upper and lower side of printed circuit boards, the upper side, with soldering paste printed onto it at predetermined points, of a printed circuit board (5), and the underside, provided with an adhesive coating at predetermined points, of a previously turned printed circuit board (6) being transported next to each other and synchronously through the same SMD insertion machine, to form a single component-insertion blank.

## Revendications

1. Procédé de mise en place automatique de composants CMS sur la face supérieure et la face inférieure de plaques à circuit imprimé, selon lequel,
on transporte une plaque à circuit imprimé (5) dont la face supérieure a reçu une impression de pâte à souder à des endroits prédéterminés et une plaque à circuit imprimé (6) préalablement retournée, et dont la face inférieure est munie d'application de colle à des endroits prédéterminés, pour former un unique flan à garnir, de manière juxtaposée et on les transporte en synchronisme à travers la même machine à planter les composants CMS.
